# EUROPEAN PATENT SPECIFICATION

(11) **EP 0 485 969 B1**
(45) Date of publication and mention of the grant of the patent: **23.07.1997**
(21) Application number: 91119327.4
(22) Date of filing: 13.11.1991
(51) Int. Cl.: H03K 17/08, G01R 19/165, H03K 3/288

(54) **Current limiting circuits**
Schaltkreise zur Strombegrenzung
Circuits pour limiter un courant

(30) Priority: 16.11.1990 JP 310875/90; 21.10.1991 JP 272199/91
(43) Date of publication of application: 20.05.1992
(73) Proprietor: KABUSHIKI KAISHA TOSHIBA, Kawasaki-shi, Kanagawa-ken 210 (JP)
(72) Inventor: Yamakawa, Isao, c/o Intellectual Property Div., Minato-ku, Tokyo 105 (JP)
(74) Representative: Lehn, Werner, Dipl.-Ing.

(56) References cited:
- DE-A- 3 433 538
- FR-A- 2 619 972
- US-A- 3 930 172
- US-A- 4 590 392
- ELECTRO. vol. 11, no. 10/4, 1986, LOS ANGELES US pages 1 - 4; ZAREMBA: 'HOW CURRENT SENSE TECHNOLOGY IMPROVES POWER MOSFET...'

## Description

The present invention relates to current-limiting circuits for limiting the output current of a power device when the low voltages rises above a predetermined value.

US 3,930,172 discloses an input supply independent circuit having a first transistor, whose base and connector are connected to each other, a second transistor, whose collector is connected to the emitter of said first transistor, a third transistor, whose base is connected to the base of said first transistor and whose emitter is connected to the base of said first transistor and a fourth transistor, whose base is connected to the emitter of said first transistor and whose collector is connected to the emitter of said third transistor. The circuit operates as a voltage regulator, wherein the voltage developed across a resistor in the emitter path of one of the transistors has a value other than zero, if the emitter areas of the transistors are of different values.

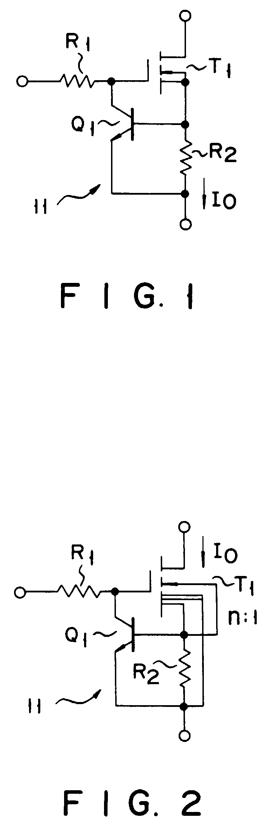

Fig. 1 shows a power device T₁ designed to function as a main switch, and also a current-limiting circuit 11 for limiting the current flowing through the power device T₁. The current-limiting circuit 11 comprises a lateral NPN transistor Q₁ and two resistors R₁ and R₂ (e.g., diffusion resistors, polysilicon registers, or aluminum wiring). Advantageously, this circuit 11 can be formed on a chip, by a method substantially identical to the method of manufacturing a discrete power transistor.

The current-limiting circuit 11 can restrict the output current I_{O} of the power device T₁. More precisely, when the output current I_{O} increases over the value I_{OL} given below, the transistor Q₁ is turned on, thereby limiting the output current I_{O} of the power device T₁.${\text{I}}_{\text{O}} {\text{≧ I}}_{\text{OL}} \text{≈} \frac{{\text{V}}_{\text{BEQ1}}}{{\text{R}}_{\text{2}}}$

To limit the output current I_{O} of the device T₁, the voltage drop made by the resistor R₂ must be greater than the voltage V_{BEQ1} which turns on the transistor Q₁. Inevitably, the current-limiting circuit 11 has a great power loss P_{D}, which is given as follows:${\text{P}}_{\text{D}} {\text{= I}}_{\text{OL}} {\text{× V}}_{\text{BEQ1}} {\text{= I}}_{\text{OL}} {\text{}}^{\text{2}} {\text{× R}}_{\text{2}}$

In practice, not only the power loss P_{D}, but also the power loss P_{D}' should be considered, which is made by the register R_{DS} existing between the drain and source of he power device T₁. The total power loss P_{DT} in the circuit comprised of the device T₁ and the circuit 11 is, therefore, considerably large, as can be understood from the following equation (3).${\text{P}}_{\text{DT}} {\text{= P}}_{\text{D}} {\text{+ P}}_{\text{D}} {\text{' = I}}_{\text{OL}} {\text{(V}}_{\text{BEQ1}} {\text{+ V}}_{\text{DS(ON)}} \text{)} {\text{= I}}_{\text{OL}} {\text{}}^{\text{2}} {\text{(R}}_{\text{2}} {\text{+ R}}_{\text{DS}} \text{)}$ where V_{DS(ON)} is the drain-source voltage of the power device T₁.

Fig. 2 shows a power device T₁ designed to function as a main switch and developed to solve the problem with the circuit shown in Fig. 1, and also a current-limiting circuit 11 identical to the circuit 11 shown in Fig. 1, used for limiting the current flowing through the power device T₁. As is evident from Fig. 2, the power device T₁ comprises a plurality of small cells. The small cells are divided into two groups, the first consisting of n times as many cells as the the second group, where n is a number greater than 1. Hence, the output current I_{O} of the device T₁ is divided into two two parts having magnitudes n and 1, respectively. Hence, the current I_{O}', defined below, is supplied to the resistor R₂.${\text{I}}_{\text{O}} \text{' =} \frac{\text{1}}{\text{N + 1}} {\text{· I}}_{\text{O}}$

In the circuit shown in Fig. 2, when the output current I_{O} of the power device T₁ increases above the value I_{OL} defined by equation (5), the transistor Q₁ is turned on, whereby the current I_{O} is limited.${\text{I}}_{\text{O}} {\text{≧ I}}_{\text{OL}} \text{≈ (n + 1) ·} \frac{{\text{V}}_{\text{BEQ1}}}{{\text{R}}_{\text{2}}}$

If n >> 1, the power loss PD made by the resistor R₂ can be neglected. Therefore, it suffices to consider the power loss P_{D}' resulting from the drain-source resistor R_{DS} of the power device T₁. Hence, the total power loss P_{DT} in the circuit comprised of the device T₁ and the circuit 11 is less than that in the circuit of Fig. 1.${\text{P}}_{\text{DT}} {\text{= P}}_{\text{D}} {\text{' = I}}_{\text{OL}} {\text{× V}}_{\text{DS(ON)}} {\text{= I}}_{\text{OL}} {\text{}}^{\text{2}} {\text{× R}}_{\text{DS}}$

To cause a current to flow through the power device T₁, the following relation (7) must avail:${\text{V}}_{\text{DS(ON)}} {\text{> V}}_{\text{BEQ1}}$

The total power loss P_{D} in the circuit of Fig. 2 is greater than I_{L} V_{BEQ1} as can be understood from the following equation:${\text{P}}_{\text{DT}} {\text{= I}}_{\text{OL}} {\text{× V}}_{\text{DS(ON)}} {\text{> I}}_{\text{OL}} {\text{× V}}_{\text{BEQ1}}$

In either conventional current-limiting circuit 11 described above, use is made of the base-emitter voltage V_{BEQ1} (about 0.6 V) of the transistor Q₁ to detect the output current I_{O} of the power device T₁. The power loss P_{DT} of the circuit comprising the device T1 and the circuit 11 is inevitably large.

The object of the invention is to provide a current-limiting circuit for limiting the output current of an intermediate or high power transistor with low total power loss.

This object is solved by a current-limiting circuit comprising, besides a power device having a control electrode : a first resistor connected at one end to the control electrode of the power device, and at the other end to the voltage source for the low-voltage detecting circuit; a second resistor connected to the output of the power device, for detecting the output current of the power device; and a third resistor connected at one end to the voltage source, and at the other end to the collector of the first transistor of the low-voltage detecting circuit. The collector of the third transistor is connected to the control electrode of the power device. The emitter of the second transistor is connected to the first end of the second resistor. The emitter of the fourth transistor is connected to the second end of the second resistor.

This object is further solved by a current-limiting circuit, comprising: a power device having a control electrode for receiving a control input; a resistor for detecting an output current of said power device, said resistor having a first end connected to the power device and a second end; a first transistor whose base and collector are connected to each other, and whose collector is connected to a current source; a second transistor whose collector is connected to the emitter of said first transistor, and whose emitter is connected to the first end of said resistor; a third transistor whose base is connected to the base of said first transistor, and whose emitter is connected to the base of said second transistor; and a fourth transistor whose base is connected to the emitter of said first transistor, whose collector is connected to the emitter of said third transistor and whose emitter is connected to the second end of said resistor, wherein an output signal is output from the collector of said third transistor when the output current of said power device increases over a predetermined value to limit the output current of said power device in response thereto. In this current-limiting device, the collector current (OUTPUT) of the third transistor can be utilized for various purposes with high efficiency.

Further advantageous embodiments and improvements of the invention may be taken from the dependent claims.

This invention can be more fully understood from the following detailed description when taken in conjunction with the accompanying drawings, in which:
Figs. 1 and 2 are diagrams showing two conventional current-limiting circuits, respectively;
Fig. 3 is a circuit diagram showing an example of a low-voltage detecting circuit
Fig. 4 is a circuit diagram showing a modification of the low-voltage detecting circuit shown in Fig. 3;
Fig. 5 is a circuit diagram showing a circuit designed to limit the output current of a power transistor and having the low-voltage detecting circuit shown in Fig. 1 according to an embodiment of the invention;
Fig. 6 is a graph representing the relationship between the gate-source voltage V_{GS} and output current I₀ of a main power transistor;
Figs. 7 and 8 are circuit diagrams showing two modifications of the current-limiting circuit shown in Fig. 5 illustrating further embodiment of the invention; and
Figs. 9 and 10 are circuit diagrams showing further examples of low-voltage detecting circuits.

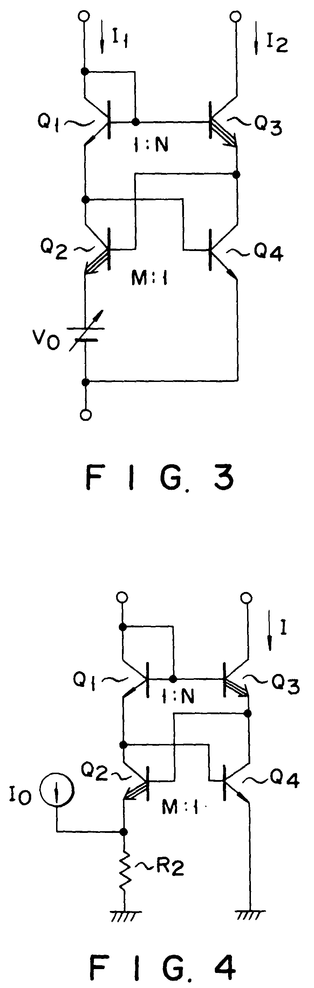

Embodiments of the present invention will now be described, with reference to the accompanying drawings. First, Fig. 3 shows an example of a low-voltage detecting circuit, which comprises four lateral NPN transistors Q₁, Q₂, Q₃, and Q₄. The transistor Q₃ has an emitter area N times greater than that of the transistor Q₁, where N is a number other than 1. The transistor Q₂ has an emitter area M times greater than that of the transistor Q₄. A current I₁ is supplied to the transistors Q₁ and Q₂, operating these transistors, and also to the base of the transistor Q₃. The low-voltage detecting circuit is designed to detect a low voltage V₀. A control current I₂ flows through the circuit when the low voltage V₀ rises above a predetermined value V_{OL}.

The voltage V_{OL} can be calculated as follows, from the base-emitter voltages of the transistors Q₁ to Q₄. First, the currents I₁ and I₂ are given as follows:${\text{I}}_{\text{1}} {\text{= I}}_{\text{sat1}} \text{· e} {\text{}}^{\frac{\text{q}}{\text{kT}} {\text{V}}_{\text{BEQ1}}} {\text{= M · I}}_{\text{sat2}} \text{· e} {\text{}}^{\frac{\text{q}}{\text{kT}} {\text{V}}_{\text{BEQ2}}}$${\text{I}}_{\text{2}} {\text{= N · I}}_{\text{sat1}} \text{· e} {\text{}}^{\frac{\text{q}}{\text{kT}} \text{VBEQ3}} {\text{= I}}_{\text{sat2}} \text{· e} {\text{}}^{\frac{\text{q}}{\text{kT}} {\text{V}}_{\text{BEQ4}}}$

The base-emitter voltages of the transistors Q₁ to Q₄ have the following relationship:${\text{V}}_{\text{BEQ1}} {\text{+ V}}_{\text{BEQ4}} {\text{= V}}_{\text{BEQ3}} {\text{+ V}}_{\text{BEQ2}} {\text{+ V}}_{\text{OL}} {\text{V}}_{\text{OL}} {\text{= V}}_{\text{BEQ1}} {\text{- V}}_{\text{BEQ2}} {\text{+ V}}_{\text{BEQ4}} {\text{- V}}_{\text{BEQ3}}$

Equation (9) can be formed into the following equation (9)':${\text{V}}_{\text{BEQ1}} {\text{- V}}_{\text{BEQ2}} \text{=} \frac{\text{kT}}{\text{q}} \text{ℓn(} \frac{{\text{M·I}}_{\text{sat2}}}{{\text{I}}_{\text{sat1}}} \text{)}$ equation (10) can be transformed into the following equation (10)':${\text{V}}_{\text{BEQ4}} {\text{- V}}_{\text{BEQ3}} \text{=} \frac{\text{kT}}{\text{q}} \text{ℓn(} \frac{{\text{N·I}}_{\text{sat1}}}{{\text{I}}_{\text{sat2}}} \text{)}$

From equations (9)' and (10)', the voltage V_{OL} is found to have the value given as follows:${\text{V}}_{\text{OL}} \text{=} \frac{\text{kT}}{\text{q}} \text{ℓn(N·M)}$

Equation (12) shows that the voltage V_{OL} does not depend on the current I₂. Rather, it is determined by the ratio of the emitter area of the transistor Q₁ to that of the transistor Q₃, and also by the ratio of the emitter area of the transistor Q₂ to that of the transistor Q₄. In other words, the low voltage V₀ (= V_{OL}), which is defined by equation (12), can be detected by selecting appropriate values for N and M. In addition, the power loss of the low-voltage detecting circuit can be less than that of the conventional one, since the voltage V_{OL} can be far lower than the base-emitter voltage of, for example, the transistor Q₁ shown in Fig. 1.

The control current i2 and the detected voltage V₀ can have the following relationships:
(1) When V₀ < V_{OL}, I₂ ≈ 0
(2) When V₀ = V_{OL}, I₂ increases exponentially
(3) When V₀ > V_{OL}, I₂ keeps flowing until it reaches the maximum value determined by the current I₁ and the current ability (e.g., amplification factor) of the NPN transistors.

Fig. 4 shows a modification of the low-voltage detecting circuit shown in Fig. 3. This circuit is identical to the circuit of Fig. 3, except that a resistor R₂ and a current source I₀ are used in place of the low voltage V₀. In this circuit, when a current I₀ increases over a predetermined current I_{OL} defined by the following equation (13), the control current I2 can flow through the transistors Q₃ and Q₄.${\text{I}}_{\text{OL}} \text{=} \frac{\text{1}}{\text{R2}} \text{·} \frac{\text{kT}}{\text{q}} \text{ℓn(M·N)}$

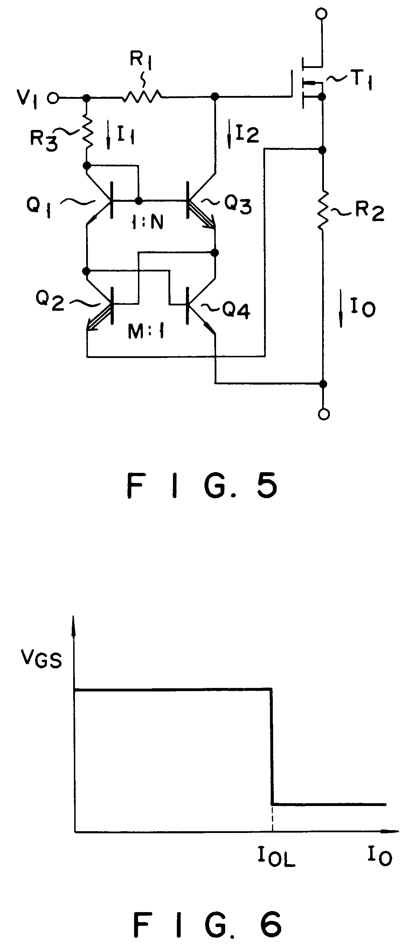

Fig. 5 shows a circuit which is designed to limit the output current of a power transistor and having the low-voltage detecting circuit shown in Fig. 1 according to an embodiment of the invention. In this circuit, the output current I₀ of a power MOSFET T₁ is supplied to a resistor R₂, thereby detecting the low voltage applied to a resistor R₂. In the current-limiting circuit shown in Fig. 5, V_{OL} = I_{OL} × R₂, where I_{OL} is the maximum current the power MOSFET T₁ can output. Based on this, equation (12) can be transformed into the following equation (14):${\text{I}}_{\text{OL}} \text{=} \frac{\text{1}}{{\text{R}}_{\text{2}}} \text{·} \frac{\text{kT}}{\text{q}} \text{ℓn(N·M)}$

Hence, when the output current I_{O} is less than the maximum output current I_{OL} (namely, I_{O} < I_{OL}), the current I₂ flowing through the transistors Q₃ and Q₄ are substantially nil. In other words, the gate-source voltage V_{GS} of the power MOSFET T₁ is V₁ - R₂ × I₀, where V₁ is the voltage applied to a terminal 12, which is higher than the voltage V_{GS(ON)} required to turn on the power MOSFET T₁. Since R₂ × I₀ has an extremely small value, V_{GS} is nearly equal to V₁. Thus, the power MOSFET T₁ is on at all times, and its output current I_{O} is not limited at all.

Conversely, when the output current I_{O} is equal to or greater than the maximum output current I_{OL} (namely, I_{O} ≧ I_{OL}), the current I₂ flowing through the transistors Q₃ and Q₄ increases greatly. As a result, the gate voltage V_{G} of the power MOSFET T₁ changes to V₁ - R₁ × I₂. Hence, the gate-source voltage V_{GS} of the power MOSFET T₁ changes to about V₁ - R₁ × I₂. In other words. Thus, the power MOSFET T₁ is turned off when the voltage V_{GS} falls below the voltage V_{GS(ON)}. Then, the output current I_{O} of the power MOSFET T₁ is limited.

Fig. 6 represents the relationship between the gate-source voltage V_{GS} and output current I₀ of the power MOSFET T₁. As can be understood from Fig. 6, the gate-source voltage VGS abruptly falls when the output current I₀ increases over the maximum value I_{OL}. Obviously, the output current I₀ of the power MOSFET T₁ is limited.

The power MOSFET and the current-limiting circuit for limiting the output current of the MOSFET, both shown in Fig. 5, can be fabricated in one and the same step of the method of manufacturing an ordinary discrete power transistor. The resistor R₂ can be formed of an aluminum wire or a bonding wire. In addition, the power device is not limited to a power MOSFET, and can be a bipolar type transistor e.g., insulated gate bipolar transistor.

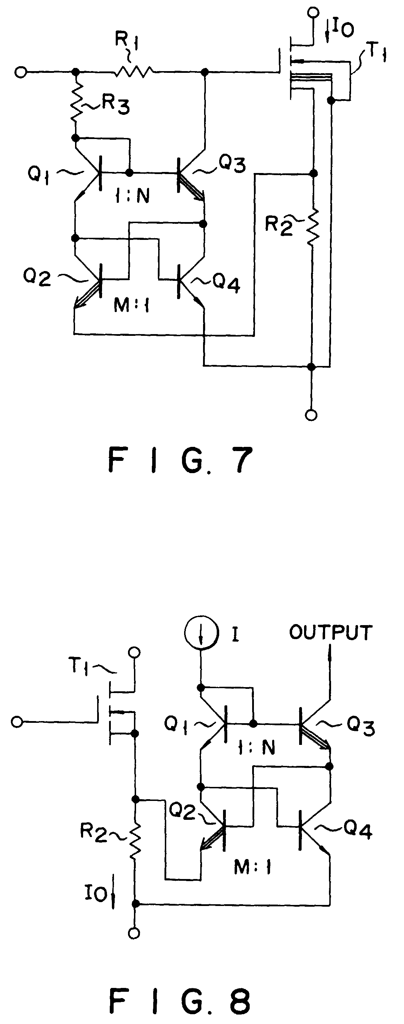

Two further embodiments of the current-limiting circuit shown in Fig. 5 will now be described, with reference to Figs. 7 and 8.

The circuit shown in Fig. 7 is characterized in that the small cells constituting a power transistor T1 are divided into two groups. The first consisting of n times as many cells as the second group, where n is a number greater than 1. The output current I_{O} of the power device T₁ is, therefore, divided into two parts having magnitudes n and 1, respectively. Hence, the current I_{O}', defined below, is supplied to the resistor R₂. Hence, 1/(n+1) of the current I_{O} flows to a resistor R₂, thereby generating a low voltage V_{O}. In this current-limiting circuit, even if the output current I_{O} is too large, it is unnecessary to decrease the resistance of the resistor R₂ in order to obtain the low voltage V_{O}. This helps to reduce the difference in resistance among the resistors which are to be used as resistor R₂.

The circuit shown in Fig. 8 is characterized in that a control output is obtained from the collector of a transistor Q₃. This current-limiting circuit serves effectively, not only to limit the output current I_{O} of the power MOSFET T₁, but also to utilize the output current I_{O} with high efficiency.

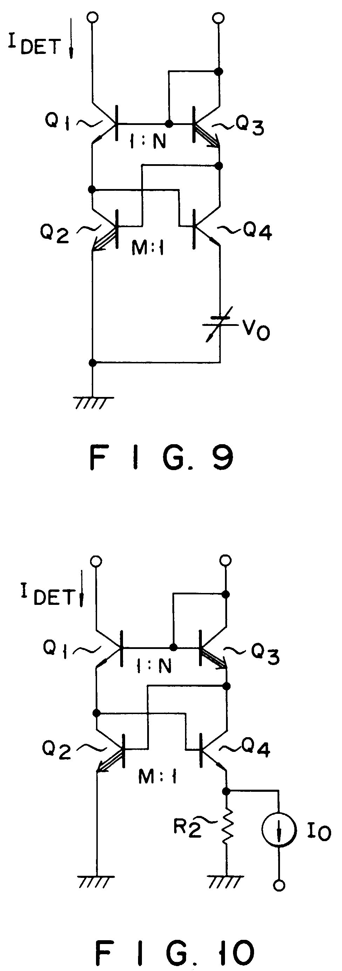

Figs. 9 and 10 show two further examples of low-voltage detecting circuits.

In the low-voltage detecting circuit shown in Fig. 3, a low voltage V_{O} is applied to the emitter of the transistor Q₂, and the ground voltage is applied to the emitter of the transistor Q₄. This circuit is, there fore, a "low positive-voltage detecting circuit."

By contrast, in the low-voltage detecting circuit of Fig. 9, the ground voltage is applied to the emitter of a transistor Q₂, and a low voltage V_{O} is applied to the emitter of a transistor Q₄. The circuit is, there fore, a "low negative-voltage detecting circuit." In the circuit of Fig. 9, if V_{O} > V_{OL}, where V_{O} is the detected voltage and V_{OL} is a predetermined voltage, then I_{DET} 0; and if V_{O} ≦ V_{OL}, I_{DET} > 0. The circuit can, therefore, detect the low voltage V_{O}.

The low-voltage detecting circuit shown in Fig. 10 is, so to speak, a modification of the circuit shown in Fig. 9. In this circuit, the low voltage V_{O} generated by a resistor R₂ and a current source I_{O}. When the absolute value of a current I_{O} decreases to or below a predetermined value I_{OL}, a control current I_{DET} can flow through transistors Q₁ and Q₂, as can be understood from equation (15). When the absolute value of a current I_{O} increases above the predetermined value I_{OL}, the control current I_{DET} cannot flow through the transistor Q₁ or Q₂, as can be understood from equation (16).

When$\left|{\text{I}}_{\text{O}}\right| \text{≦} \frac{\text{1}}{\text{R2}} \text{·} \frac{\text{kT}}{\text{q}} \text{ℓn(N·M)} {\text{I}}_{\text{DET}} \text{> 0,}$

When$\left|{\text{I}}_{\text{O}}\right| \text{>} \frac{\text{1}}{\text{R2}} \text{·} \frac{\text{kT}}{\text{q}} \text{ℓn(N·M)} {\text{I}}_{\text{DET}} \text{≈ 0,}$

As has been explained, the above low-voltage detecting circuit can detect the low voltage V_{OL} which is determined by the ratio of the emitter area of the transistor Q₁ to that of the transistor Q₃, and also by the ratio of the emitter area of the transistor Q₂ to that of the transistor Q₄. Hence, the circuit serves to limit the output current of a power device. In addition, since the output current of the power device is limited by detecting the low voltage V_{OL}, the power loss of the low-voltage detecting circuit is far less than that of the conventional one. For instance, if M = N = 3, the circuit can detect a voltage which is about ten times lower than the base-emitter voltage V_{BE} of the NPN transistors Q₁ to Q₄. Further, the power MOSFET and the current-limiting circuit, both incorporated in the embodiments of Figs. 5 and 7, can be fabricated in one and the same step of the method of manufacturing an ordinary discrete power transistor. The embodiments of Figs. 5 and 7 can, therefore, provide a power device having a current-limiting section.

## Claims

1. A current-limiting circuit comprising:
a power device (T₁) having a control electrode;
a first resistor (R₁) connected at one end to the control electrode of said power device (T1), and at the other end to a potential source (V1);
a second resistor (R₂) for detecting a current output (I0) by said power device (T1);
a first transistor (Q₁) whose base and collector are connected to each other;
a second transistor (Q₂) whose collector is connected to the emitter of said first transistor (Q1) and whose emitter is connected to one end of said second resistor (R2);
a third transistor (Q₃) whose base is connected to the base of said first transistor (Q1), and whose collector is connected to the control electrode of said power device (T1) and whose emitter is connected to the base of said second transistor (Q2);
a fourth transistor (Q₄) whose base is connected to the emitter of said first transistor (Q1), and whose collector is connected to the emitter of said third transistor (Q3) and whose emitter is connected to the other end of said second transistor (Q2); and
a third resistor (R₃) connected at one end to said potential source (V1) and at the other end to the collector of said first transistor (Q1),
wherein the output current (I0) of said power device (T1) is limited when the output current (I0) of said power device (T1) increases over a predetermined value.

2. The circuit according to claim 1, characterized in that the ratio of the emitter area of said first transistor (Q1) to that of said third transistor (Q3) is 1:N, where N is a number other than 1, and the ratio of the emitter area of said second transistor (Q2)) to that of said fourth transistor (Q4) is M:1, where M is a number other than 1.

3. The circuit according to claim 1, characterized in that said power device (T1) is a power MOSFET.

4. The circuit according to claim 1, characterized in that the output current I_{O} is divided into two parts, the first part being n times greater than the second part, where n is a number greater than 1, and a current of I_{O}/(n+1) flows to said second resistor (R2).

5. A circuit comprising:
a power device (T1) having a control electrode for receiving a control input;
a resistor (R2) for detecting an output current (I_{O}) of said power device (T1), said resistor (R2) having a first end connected to the power device (T1) and a second end;
a first transistor (Q1) whose base and collector are connected to each other, and whose collector is connected to a current source (I);
a second transistor (Q2) whose collector is connected to the emitter of said first transistor (Q1), and whose emitter is connected to the first end of said resistor (Q2);
a third transistor (Q3) whose base is connected to the base of said first transistor (Q1), and whose emitter is connected to the base of said second transistor (Q2); and
a fourth transistor (Q4) whose base is connected to the emitter of said first transistor (Q1), whose collector is connected to the emitter of said third transistor (Q3) and whose emitter is connected to the second end of said resistor (R2),
wherein an output signal (OUTPUT) is output from the collector of said third transistor (Q3) when the output current (I_{O}) of said power device (T1) increases over a predetermined value to limit the output current of said power device in response thereto.

6. The circuit according to claim 5, wherein the ratio of the emitter area of said first transistor (Q1) to that of said third transistor (Q3) is 1:N, where N is a number other than 1, and the ratio of the emitter area of said second transistor (Q2) to that of said fourth transistor (Q4) is M:1, where M is a number other than 1.

7. The circuit according to claim 5, wherein said power device (T1) is a power MOSFET.

## Patentansprüche

1. Strombegrenzungsschaltung, umfassend:
eine Leistungseinrichtung (T₁) mit einer Steuerelektrode;
einen ersten Widerstand (R₁), der an einem Ende mit der Steuerelektrode der Leistungseinrichtung (T₁) und an dem anderen Ende mit einer Potentialquelle (V1) verbunden ist;
einen zweiten Widerstand (R₂) zum Erfassen eines Stromausgangs (I0) von der Leistungseinrichtung (T1);
einen ersten Transistor (Q₁), dessen Basis und Kollektor zusammengeschaltet sind;
einen zweiten Transistor (Q₂), dessen Kollektor mit dem Emitter des ersten Transistors (Q1) verbunden ist und dessen Emitter mit einem Ende des zweiten Widerstands (R2) verbunden ist;
einen dritten Transistor (Q₃), dessen Basis mit der Basis des ersten Transistors (Q1) verbunden ist und dessen Kollektor mit der Steuerelektrode der Leistungseinrichtung (T1) verbunden ist und dessen Emitter mit der Basis des zweiten Transistors (Q2) verbunden ist;
einen vierten Transistor (Q4), dessen Basis mit dem Emitter des ersten Transistors (Q1) verbunden ist und dessen Kollektor mit dem Emitter des dritten Transistors (Q3) verbunden ist und dessen Emitter mit dem anderen Ende des zweiten Transistors (Q2) verbunden ist; und
einen dritten Widerstand (R₃), der an einem Ende mit der Potentialquelle (V1) und an dem anderen Ende mit dem Kollektor des ersten Transistors (Q1) verbunden ist,
wobei der Ausgangsstrom (I0) der Leistungseinrichtung (T1) begrenzt wird, wenn der Ausgangsstrom (I0) der Leistungseinrichtung (T1) über einen vorgegebenen Wert ansteigt.

2. Schaltung nach Anspruch 1, dadurch gekennzeichnet, daß das Verhältnis der Emitterfläche des ersten Transistors (Q1) zu derjenigen des dritten Transistors (Q3) 1:N ist, wobei N eine Zahl größer als 1 ist und wobei das Verhältnis der Emitterfläche des zweiten Transistors (Q2) zu derjenigen des vierten Transistors (Q4) M:1 ist, wobei M eine andere Zahl als 1 ist.

3. Schaltung nach Anspruch 1, dadurch gekennzeichnet, daß die Leistungseinrichtung (T1) ein Leistungs-MOSFET ist.

4. Schaltung nach Anspruch 1, dadurch gekennzeichnet, daß der Ausgangsstrom (I₀) in zwei Teile aufgeteilt ist, wobei der erste Teil n-mal so groß wie der zweite Teil ist, wobei n eine Zahl größer als 1 ist und wobei ein Strom von I₀/(n+1) an den zweiten Widerstand (R2) fließt.

5. Schaltung, umfassend:
eine Leistungseinrichtung (T1) mit einer Steuerelektrode zum Empfangen eines Steuereingangs;
einen Widerstand (R2) zum Erfassen eines Ausgangsstroms (I₀) der Leistungseinrichtung (T1), wobei der Widerstand (R2) ein mit der Leistungseinrichtung (T1) verbundenes erstes Ende und ein zweites Ende aufweist;
einen ersten Transistor (Q1), dessen Basis und Kollektor zusammengeschaltet sind und dessen Kollektor mit einer Stromquelle (I) verbunden ist;
einen zweiten Transistor (Q2), dessen Kollektor mit den Emitter des ersten Transistors (Q1) verbunden ist und dessen Emitter mit dem ersten Ende des Widerstands (Q2) verbunden ist;
einen dritten Transistor (Q3), dessen Basis mit der Basis des ersten Transistors (Q1) verbunden ist und dessen Emitter mit der Basis des zweiten Transistors (Q2) verbunden ist;
einen vierten Transistor (Q4), dessen Basis mit dem Emitter des ersten Transistors (Q1) verbunden ist, dessen Kollektor mit dem Emitter des dritten Transistors (Q3) verbunden ist und dessen Emitter mit dem zweiten Ende des Widerstands (R2) verbunden ist,
wobei ein Ausgangssignal (AUSGANG) von dem Kollektor des dritten Transistors (Q3) ausgegeben wird, wenn der Ausgangsstrom (I₀) der Leistungseinrichtung (T1) über einen vorgegebenen Wert ansteigt, um den Ausgangsstrom der Leistungseinrichtung im Ansprechen darauf zu begrenzen.

6. Schaltung nach Anspruch 5, wobei das Verhältnis der Emitterfläche des ersten Transistors (Q1) zu derjenigen des dritten Transistors (Q3) 1:N ist, wobei N eine andere Zahl als 1 ist und wobei das Verhältnis der Emitterfläche des zweiten Transistors (Q2) zu derjenigen des vierten Transistors (Q4) M:1 ist, wobei M eine andere Zahl als 1 ist.

7. Schaltung nach Anspruch 5, dadurch gekennzeichnet, daß die Leistungseinrichtung (T1) ein Leistungs-MOSFET ist.

## Revendications

1. Circuit limiteur de courant comprenant :
un dispositif de puissance (T₁) comportant une électrode de commande ;
une première résistance (R₁) connectée, à une première extrémité, à l'électrode de commande dudit dispositif de puissance (T₁) et, à l'autre extrémité, à une source de potentiel (V₁) ;
une seconde résistance (R₂) pour détecter une sortie de courant (I₀) par ledit dispositif de puissance (T₁) ;
un premier transistor (Q₁) dont la base et le collecteur sont connectés l'un à l'autre ;
un second transistor (Q₂) dont le collecteur est connecté à l'émetteur dudit premier transistor (Q₁) et dont l'émetteur est connecté à une première extrémité de ladite seconde résistance (R₂) ;
un troisième transistor (Q₃) dont la base est connectée à la base dudit premier transistor (Q₁), dont le collecteur est connecté à l'électrode de commande dudit dispositif de puissance (T₁) et dont l'émetteur est connecté à la base dudit second transistor (Q₂) ;
un quatrième transistor (Q₄) dont la base est connectée à l'émetteur dudit premier transistor (Q₁), dont le collecteur est connecté à l'émetteur dudit troisième transistor (Q₃) et dont l'émetteur est connecté à l'autre extrémité dudit second transistor (Q₂) ; et
une troisième résistance (R₃) connectée, à une première extrémité, à ladite source de potentiel (V₁) et, à l'autre extrémité, au collecteur dudit premier transistor (Q₁),
dans lequel le courant de sortie (I₀) dudit dispositif de puissance (T₁) est limité lorsque le courant de sortie (I₀) dudit dispositif de puissance (T₁) augmente au-dessus d'une valeur prédéterminée.

2. Circuit selon la revendication 1, caractérisé en ce que le rapport de la surface d'émetteur dudit premier transistor (Q₁) sur celle dudit troisième transistor (Q₃) est de 1:N, où N est un nombre autre que 1, et le rapport de la surface d'émetteur dudit second transistor (Q₂) sur celle dudit quatrième transistor (Q₄) est de M:1, où M est un nombre autre que 1.

3. Circuit selon la revendication 1, caractérisé en ce que ledit dispositif de puissance (T₁) est un transistor MOS à effet de champ de puissance.

4. Circuit selon la revendication 1, caractérisé en ce que le courant de sortie I₀ est divisé en deux parties, la première partie étant n fois plus grande que la seconde partie, où n est un nombre supérieur à 1, et en ce qu'un courant I₀/(n+1) circule vers ladite seconde résistance (R₂).

5. Circuit comprenant :
un dispositif de puissance (T₁) comportant une électrode de commande pour recevoir une entrée de commande ;
une résistance (R₂) pour détecter un courant de sortie (I₀) dudit dispositif de puissance (T₁), ladite résistance (R₂) comportant une première extrémité connectée au dispositif de puissance (T₁) et une seconde extrémité ;
un premier transistor (Q₁) dont la base et le collecteur sont connectés l'un à l'autre et dont le collecteur est connecté à une source de courant (I) ;
un second transistor (Q₂) dont le collecteur est connecté à l'émetteur dudit premier transistor (Q₁) et dont l'émetteur est connecté à la première extrémité de ladite résistance (R₂) ;
un troisième transistor (Q₃) dont la base est connectée à la base dudit premier transistor (Q₁) et dont l'émetteur est connecté à la base dudit second transistor (Q₂) ; et
un quatrième transistor (Q₄) dont la base est connectée à l'émetteur dudit premier transistor (Q₁), dont le collecteur est connecté à l'émetteur dudit troisième transistor (Q₃) et dont l'émetteur est connecté à la seconde extrémité de ladite résistance (R₂),
dans lequel un signal de sortie (SORTIE) est sorti à partir du collecteur dudit troisième transistor (Q₃) lorsque le courant de sortie (I₀) dudit dispositif de puissance (T₁) augmente au-dessus d'une valeur prédéterminée pour limiter le courant de sortie dudit dispositif de puissance en réponse à celui-ci.

6. Circuit selon la revendication 5, dans lequel le rapport de la surface d'émetteur dudit premier transistor (Q₁) sur celle dudit troisième transistor (Q₃) est de 1:N, où N est un nombre autre que 1, et le rapport de la surface d'émetteur dudit second transistor (Q₂) sur celle dudit quatrième transistor (Q₄) est de M:1, où M est un nombre autre que 1.

7. Circuit selon la revendication 5, dans lequel ledit dispositif de puissance (T₁) est un transistor MOS à effet de champ de puissance.
